# EUROPÄISCHE PATENTSCHRIFT

(11) **EP 2 087 145 B1**
(45) Veröffentlichungstag und Bekanntmachung des Hinweises auf die Patenterteilung: **28.09.2011**
(21) Anmeldenummer: 07817603.9
(22) Anmeldetag: 01.10.2007
(51) Int. Cl.: C23C 14/24

(54) **VAKUUMBESCHICHTUNGSVERFAHREN UND ANORDNUNG ZUR DURCHFÜHRUNG DES VERFAHRENS**
VACUUM COATING METHOD, AND ARRANGEMENT FOR CARRYING OUT SAID METHOD
PROCÉDÉ D'APPLICATION DE REVÊTEMENT SOUS VIDE ET DISPOSITIF PERMETTANT LA MISE EN OEUVRE DUDIT PROCÉDÉ

(30) Priorität: 29.09.2006 DE 102006046793; 29.09.2006 DE 102006046795
(43) Veröffentlichungstag der Anmeldung: 12.08.2009
(73) Patentinhaber: VON ARDENNE ANLAGENTECHNIK GMBH, 01324 Dresden (DE)
(72) Erfinder: OBST, Henrik, 01259 Dresden (DE); DEUS, Carsten, 01309 Dresden (DE); GOTTSMANN, Lutz, 01900 Kleinröhrsdorf (DE); WENZEL, Bernd-Dieter, 01909 Grosshartau-Bühlau (DE); TEICHERT, Bernd, 01277 Dresden (DE); LENK, Peter, 01324 Dresden (DE); HECHT, Hans-Christian, 01689 Weinböhla (DE)
(74) Vertreter: Lippert, Stachow & Partner
(86) Internationale Anmeldenummer: PCT/DE2007/001761
(87) Internationale Veröffentlichungsnummer: WO 2008/040329

(56) Entgegenhaltungen:
- WO-A-2005/116290
- JP-A- 2 118 064
- JP-A- 62 007 857
- US-A- 3 581 766
- US-A1- 2004 026 234

## Beschreibung

Die Erfindung betrifft ein.Vakuumbeschichtungsverfahren bei dem Verdampfungsgut durch Aufschmelzen in eine flüssige Phase gebracht wird. Aus diesem flüssigen Verdampfungsgut wird in einer Vakuumkammer, in der ein Prozessvakuum eingestellt ist, mittels eines Verdampfers ein Dampf erzeugt. Der Dampf wird innerhalb des Prozesssvakuums, d.h. innerhalb der Vakuumkammer auf eine Oberfläche eines Substrates zur Kondensierung auf dieser Substratoberfläche gebracht.

Die Erfindung betrifft auch eine Anordnung zur Durchführung des Verfahrens, die eine Vakuumkammer, in der ein Prozessvakuum einstellbar ist, aufweist. In dieser Vakuumkammer ist ein Verdampfer, der ein flüssiges Verdampfungsgut aufnimmt und dieses Verdampfungsgut verdampft, eine Substrataufnahme und eine Vorrichtung zur Zuführung von Verdampfungsgut angeordnet.

Aus dem Stand der Technik ist es bekannt, einen Verdampfer mit Verdampfergut zu beschicken, um einen Beschichtungsprozess aus der Dampfphase fortzusetzen, wenn sich das Verdampfungsgut in dem Verdampfer infolge des Aufwachsens von Schichten auf Substrate, die in der Vakuumkammer auf einer Substrathalterung festgehalten sind und auf deren Oberfläche der Dampf zu einer Beschichtung kondensiert, verbraucht.

Üblicherweise wird der Beschichtungsprozess durch möglichst große Mengen an Verdampfungsgut möglichst lange aufrecht erhalten. Damit wird eine erneute Beschickung zwar verzögert aber nicht vermieden.

Um zu einer kontinuierlichen Beschichtung zu gelangen, ist es weiterhin bekannt, mehrere Verdampferquellen zu bevorraten, die über Vakuumventile zu der Vakuumkammer zugeschalten werden können. Mittels der Vakuumventile wird es möglich, die Verdampferquellen im von der Vakuumkammer getrennten Zustand von außen erneut zu beschicken. Eine derartige Lösung eignet sich allerdings nur für relativ geringe Mengen an Verdampfungsgut und der Aufwand zur Realisierung derartiger Anlagen ist hoch.

In der WO 2005/116290A wird eine Vorrichtung zum Vakuumbeschichten und ein zugehöriges Verfahren beschrieben. Die Vorrichtung umfasst eine Vakuumkammer, ein flüssiges Verdampfungsgut aufnehmender und dieses verdampfender Verdampfer, eine Substrataufnahme und eine Vorrichtung zur Zuführung von Verdampfungsgut. Dabei ist ein Aufschmelzbehälter mit dem Verdampfer über eine Verbindungsleitung verbunden. Das Verdampfungsgut wird im Aufschmelzbehälter außerhalb der Vakuumkammer geschmolzen.

Der Erfindung liegt somit die Aufgabe zugrunde, ein Vakuumbeschichtungsverfahren und eine Anordnung zur Durchführung des Verfahrens anzugeben, mit dem eine den Beschichtungsprozess ohne Unterbrechung fortsetzende Nachbeschickung von Verdampfungsgut mit relativ zum Stand der Technik geringem Aufwand zu realisieren.

Die Aufgabe wird verfahrensseitig durch ein Vakuumbeschichtungsverfahren mit den Merkmalen des Anspruches 1 gelöst, von dem die abhängigen Ansprüche 2 bis 1 Ausführungsformen darstellen. Anordnungsseitig wird die Aufgabe durch eine Anordnung gemäß den Merkmalen des Anspruches 10 gelöst, zu dem die Ansprüche 11 bis 15 Ausführungsformen darstellen.

Ein Vakuumbeschichtungsverfahren der eingangs genannten Art sieht erfindungsgemäß vor, dass das Verdampfungsgut von außerhalb der Vakuumkammer bei ununterbrochenem Prozessvakuum in die Vakuumkammer eingebracht und dem Verdampfer über eine Verbindungsleitung fließend zugeführt wird. Damit wird erreicht, dass eine kontinuierliche Zuführung ohne Prozessunterbrechung erfolgt.

Dadurch, dass das Verdampfungsgut einem Aufschmelzbehälter innerhalb der Vakuumkammer zugeführt wird und von dieser über die Verbindungsleitung dem Verdampfer zugeführt wird, wird mit minimalem Aufwand ein Aufschmelzen des Verdampfungsgutes während des Beschichtungsprozesses erreicht. Damit kann das Verdampfungsgut über eine Schleuse in fester Form in die Vakuumkammer eingebracht und innerhalb der Vakuumkammer aufgeschmolzen werden. Je nach Verbrauch ist es dabei möglich, dass das feste Verdampfungsgut durch eine zyklisch wiederholendes Öffnen der Schleuse eingebracht wird.

Eine wechselweise Arbeit der Vorrichtung aus immer einem Aufschmelzbehälter, der auch tatsächlich flüssiges Verdampfungsgut zur Verfügung hat, wird dadurch erreicht, daas das Verdampfungsgut zu einem ersten Zeitpunkt einem ersten Aufschmelzbehälter und zu einem zweiten Aufschmelzbehälter zugeführt wird und das flüssige Verdampfungsgut nach dem ersten Zeitpunkt dem Verdampfer von dem ersten Aufschmelzbehälter und nach dem zweiten Zeitpunkt aus dem zweiten Aufschmelzbehälter zügeführt wird.

In einer Ausführungsform der Erfindung wird ein einfacher Transport des Verdampfungsgutes dadurch erreicht, dass das flüssige Verdampfungsgut dem Verdampfer nach dem Prinzip der kommunizierenden Röhren zugeführt wird. Unterstützt werden kann der Transport dadurch, dass das flüssige Verdampfungsgut dem Verdampfer durch Pumpen zugeführt wird. Dieser Transport kann selbstverständlich auch selbständig erfolgen.

Der eigentliche Aufschmelzvorgang kann auch außerhalb der Vakuumkammmer erfolgen, indem das Verdampfungsgut außerhalb der Prozesskammer aufgeschmolzen und in flüssiger Form in die Vakuumkammer eingebracht und dem Verdampfer zugeführt wird.

Durch die Beschickung wird es möglich, dass der die Höhe des Füllstandes in dem Aufschmelzbehälter geregelt wird. Damit kann direkt oder indirekt Einfluss auf den Beschichtungsprozess genommen werden, da sich damit auch die Höhe in dem Verdampfer und damit die Verdampfungsmenge ändern kann.

Sowohl der Beschichtungsprozess kann Einfluss auf den Beschichtungsvorgang nehmen, wie auch umgekehrt, indem die Zufuhr von Verdampfungsgut in Abhängigkeit von Prozessparametern gesteuert erfolgt.

Dabei kann die Höhe konstant gehalten werden und sogar ein Umlauf von Verdampfungsgut erreicht werden, indem in einem Überschuss gefördertes Verdampfungsgut über eine geheizte Rücklaufleitung in den Aufschmelzbehälter zurück geführt wird.

In der Anordnung ist ein das Verdampfungsgut schmelzender und flüssiges Verdampfungsgut aufnehmender Aufschmelzbehälter vorgesehen, der mit dem Verdampfer über eine Verbindungsleitung verbunden ist. Durch diese Verbindugsleitung kann problemlos Verdampfungsgut nachgeführt werden, wann immer es erforderlich ist. Der Prozess wird dadurch in keiner Weise beeinträchtigt.

Die Beschickung von außen geschehen und das Aufschmelzen im Inneren der Vakuumkammer, indem der Aufschmelzbehälter innerhalb der Vakuumkammer angeordnet ist und eine festes Verdampfungsgut in die Vakuumkammer einführende Zuführeinrichtung vorgesehen ist, über die der Aufschmelzbehälter ohne Unterbrechung des Prozessvakuums mit Verdampfungsgut beschickbar ist.

Dabei kann die Zuführeinrichtung eine Schleuse einschließen, über die das Verdampfungsgut in fester Form einbringbar ist.

Es kann jeweils wechselweise Verdampfungsgut nachgeführt werden, indem neben dem Aufschmelzbehälter ein zweiter alternativ mit festen Verdampfungsgut beschickbarer Aufschmelzbehälter angeordnet ist.

Alternativ oder ergänzend dazu ist es möglich, dass der Aufschmelzbehälter zur der Umgebung dicht verschließbar ist und der Druck in dem Ausgleichsbehälter atmosphärische Druckschwankungen kompensierend variierbar ist. In gleicher Weise kann mit der Verbindungsleitung eine Pumpe verbunden sein, mittels derer die wirksame Höhe der Flüssigkeitssäule in der Verbindungsleitung atmosphärische Druckschwankungen kompensierend einstellbar ist.

Eine konstante Füllhöhe und/oder ein Verdampfungsgutumlauf kann dadurch bewirkt werden, dass zwischen dem ersten Flüssigkeitsspiegel und dem zweiten Flüssigkeitsspiegel eine flüssiges Verdampfungsgut führende Überlaufleitung angeordnet ist, und eine Vakuumdichtung zwischen der Vakuumkammer und dem Aufschmelzbehälter mittels der Flüssigkeit in der Überlaufleitung bewirkt ist.

Die Erfindung soll nachfolgend anhand eines Ausführungsbeispieles näher erläutert werden. In den zugehörigen Zeichnungen zeigt
- Fig. 1: eine erfindungsgemäße Anordnung mit einem außerhalb der Vakuumkammer angeordneten Aufschmelzbehälter,
- Fig. 2: eine erfindungsgemäße Anordnung mit einem innerhalb der Vakuumkammer angeordneten Aufschmelzbehälter, der nach dem Prinzip der kommunizierenden Röhren mit dem Verdampfer verbunden ist, und
- Fig. 3: eine erfindungsgemäße Anordnung mit zwei Aufschmelzbehältern in der Vakuumkammer.

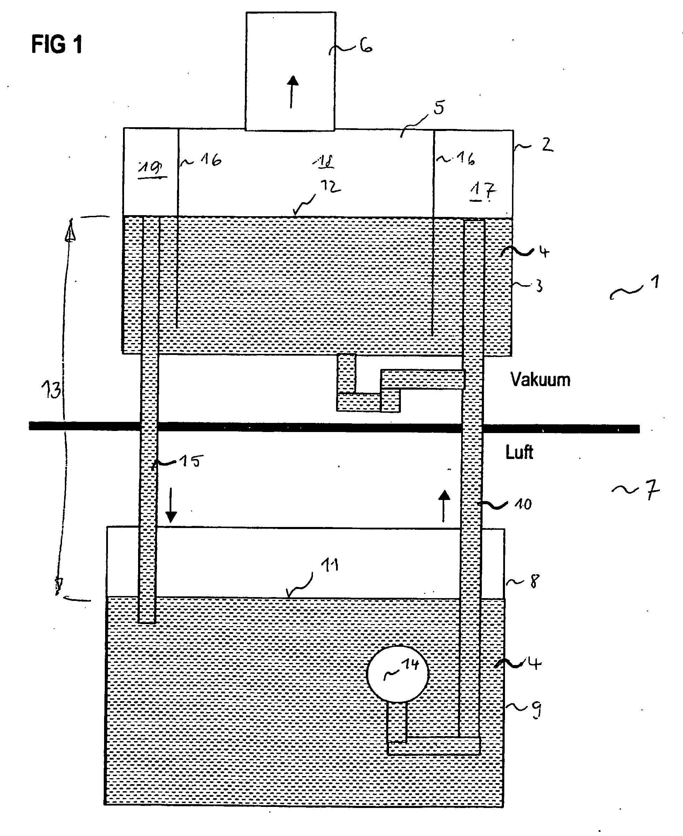

Wie in Fig. 1 dargestellt, ist in einer Vakuumkammer 1 ein Verdampfer 2 angeordnet. Dieser Verdampfer 2 weist eine Flüssigkeitswanne 3 auf, in der flüssiges Verdampfungsgut 4 aufgenommen wird. Über der Flüssigkeitswanne 3 befindet sich der Verdampferraum 5. Dieser Verdampferraum 5 ist gegenüber der Vakuumkammer 1 abgedichtet. Zur gezielten Dampfführung ist der Verdampferraum 5 mit einer Dampfleitung 6 verbunden, die den Dampf in die Nähe der in diesem Ausführungsbeispiel nicht näher dargestellten Substrat leitet.

Außerhalb der Vakuumkammer 1 und hierbei in der Umgebung der freien Atmosphäre 7 ist ein Aufschmelzbehälter 8 angeordnet. In diesen Aufschmelzbehälter wird in nicht näher dargestellter Art und Weise festes Verdampfergut eingebracht und mittels ebenfalls nicht näher dargestellten Heizeinrichtung so weit erwärmt, dass es schmilzt. Es besteht natürlich auch die Möglichkeit, dass das Verdampfungsgut bereits in der flüssigen Phase in den Aufschmelzbehälter 8 eingebracht und dort in der flüssigen Phase gehalten wird. Vorzugsweise besteht das Verdampfergut aus Metall oder metallischen Legierungen.

Das geschmolzene und damit flüssige Verdampfergut 4 befindet sich im Flüssigraum 9 des Aufschmelzbehälters 8. Von dort ist der Aufschmelzbehälter 8 mit dem Verdampfer 2 über eine Verbindungsleitung 10 verbunden.

Zur Einstellung des Füllstandes an flüssigem Verdampfergut 4 in der Flüssigkeitswanne 3 des Verdampfers 2 wird die Druckdifferenz zwischen der Vakuumkammer 1 und der freien Atmosphäre 7 ausgenutzt und zwar in der Art, dass der Aufschmelzbehälter 8 in Richtung der Schwerkraft unter der Vakuumkammer 1 angeordnet ist. Damit wird in der Verbindungsleitung 10 eine Flüssigkeitssäule erzeugt. Der Druck dieser Flüssigkeitssäule am Flüssigkeitsspiegel 11 des flüssigen Verdampfungsgutes 4 in dem Flüssigraum 9 des Aufschmelzbehälters 8 wirkt dem Druck an dem Flüssigkeitsspiegel 12, der ja dem Druck in der Vakuumkammer 1 entspricht, entgegen. Der Druckdifferenz zwischen dem Vakuum in der Vakuumkammer 1 und der freien Atmosphäre 7 entspricht also die Füllhöhe in der Flüssigkeitswanne 3. Anders ausgedrückt, kann mit der Einstellung des Abstandes 13 zwischen den beiden Flüssigkeitsspiegeln 11 und 12 die Höhe des Füllstandes in der Flüssigkeitswanne 3 eingestellt werden.

Es kann möglich sein, dass diese Einstellmöglichkeit nur unzureichend funktioniert, etwa bei Schwankungen des atmosphärischen Luftdruckes. Aus diesem Grunde ist es sinnvoll, die Verbindungsleitung 10 zusätzlich mit einer Flüssigmetallpumpe 14 zu versehen. Mit dieser kann - letzten Endes durch die Saugwirkung des Vakuums in der Vakuumkammer 1 unterstützt - flüssiges Verdampfungsgut 4 in die Flüssigkeitswanne 3 gepumpt werden.

In der Flüssigkeitswanne 3 ist nunmehr eine Rücklaufleitung 15 vorgesehen, über die über die Flüssigmetallpumpe 14 zuviel in die Flüssigkeitswanne 3 gepumptes flüssiges Verdampfergut 4 in den Aufschmelzbehälter 8 zurück strömen kann. Damit wird auch ein entsprechender Umlauf an flüssigem Verdampfungsgut 4 erzeugt, was Unterschieden in Konzentrationsverteilungen vorbeugen hilft.

In diesem wie auch in den nachfolgend geschilderten Ausführungsbeispielen sind die Verbindungsleitung 10 und die Rücklaufleitung 15 mit Heizungen versehen, die diese auf eine über die Schmelztemperatur (und vorzugsweise unter der Dampftemperatur) erwärmen des Verdampfungsgutes 4 zu erwärmen. Damit wird ein "Einfrieren" der Leitungen vermieden.

Der Verdampfer 2 selbst ist über Trennwände 16 in drei Teilvolumina 17, 18 und 19 geteilt. Die Trennwände 16 weisen im unteren Drittel des Verdampfers 2 Öffnungen auf, durch die das flüssige Verdampfungsgut 4 zwischen den Teilvolumina 17 bis 19 ausgetauscht werden kann. Die Zuführung des flüssigen Verdampfungsgutes 4 in den Aufschmelzbehälter 8 erfolgt durch Zulauf in den das erste Teilvolumen 17. Die Abführung des entstehenden Dampfes erfolgt im zweiten Teilvolumen 18 über die entsprechende Dampfleitung 6. Die Abführung von im Überschuss geförderten Verdampfungsgut 4 erfolgt durch Überlauf in der Rücklaufleitung 15 in den Aufschmelzbehälter in dem dritten Teilvolumen 19.

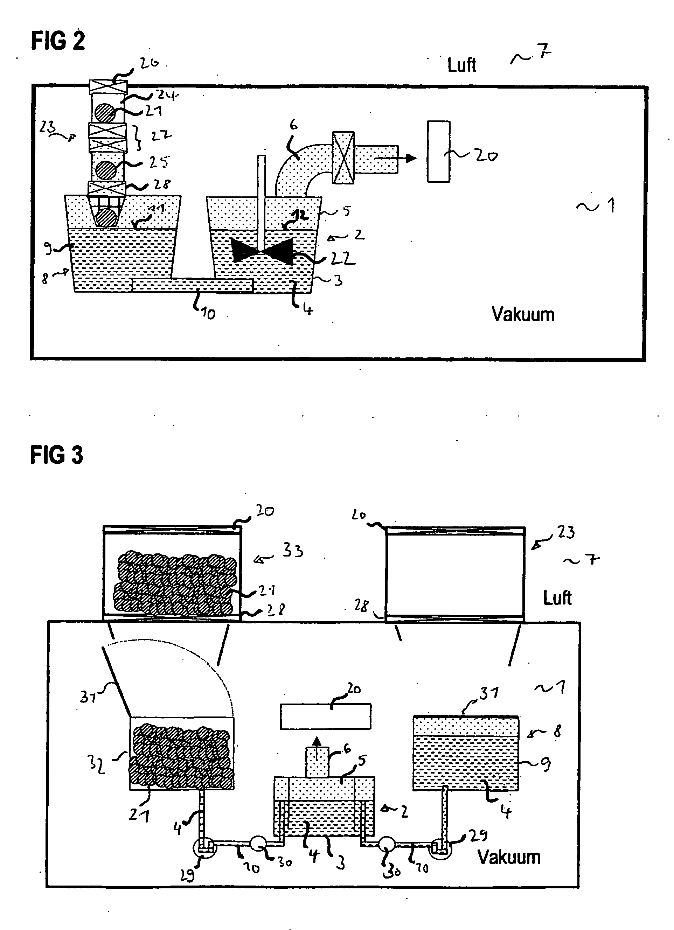

In der in Fig. 2 dargestellten Ausführungsform ist in einer Vakuumkammer 1 ein Verdampfer 2 angeordnet. Dieser Verdampfer 2 weist eine Flüssigkeitswanne 3 auf, in der flüssiges Verdampfungsgut 4 aufgenommen wird. Über der Flüssigkeitswanne 3 befindet sich der Verdampferraum 5. Dieser Verdampferraum 5 ist gegenüber der Vakuumkammer 1 abgedichtet. Zur gezielten Dampfführung ist der Verdampferraum 5 mit einer Dampfleitung 6 verbunden, die den Dampf in die Nähe des Substrat 20 leitet.

Innerhalb der Vakuumkammer 1 ist ein Aufschmelzbehälter 8 angeordnet. In diesen Aufschmelzbehälter wird festes Verdampfergut 21 eingebracht und mittels ebenfalls nicht näher dargestellten Heizeinrichtung so weit erwärmt, dass es schmilzt. Vorzugsweise besteht das Verdampfergut aus Metall oder metallischen Legierungen.

Das geschmolzene und damit flüssige Verdampfergut 4 befindet sich im Flüssigraum 9 des Aufschmelzbehälters 8. Von dort ist der Aufschmelzbehälter 8 mit dem Verdampfer 2 über eine Verbindungsleitung 10 nach dem Prinzip der kommunizierende Röhren verbunden, was bedeutet, dass der Flüssigkeitsspiegel 11 im gleichen Maße sinkt oder steigt, wie der Flüssigkeitsspiegel 12.

Zur Vermeidung von Konzentrationsunterschieden innerhalb des flüssigen Verdampfungsgutes 4 ist in dem Verdampfer 2 ein Rührwerk 22 angeordnet, was das Verdampfungsgut 4 in ständiger Bewegung hält.

Zwischen der freien Atmosphäre 7 und der Vakuumkammer 1 ist eine Schleuse 23 angeordnet. Diese Schleuse 23 besteht aus zwei Schleusenkammern 24 und 25 die durch ein jeweils getrennt schaltbares äußeres Ventil 26, mittleres Ventilsystem 27 und inneres Ventil 28 trennbar sind. Durch diese Schleuse 23 wird nunmehr das feste Verdampfungsgut 21 dem Aufschmelzbehälter 8 zugeführt.

In der in Fig. 3 dargestellten Ausführungsform ist in einer Vakuumkammer 1 ein Verdampfer 2 angeordnet. Dieser Verdampfer 2 weist eine Flüssigkeitswanne 3 auf, in der flüssiges Verdampfungsgut 4 aufgenommen wird. Ober der Flüssigkeitswanne 3 befindet sich der Verdampferraum 5. Dieser Verdampferraum 5 ist gegenüber der Vakuumkammer 1 abgedichtet. Zur gezielten Dampfführung ist der Verdampferraum 5 mit einer Dampfleitung 6 verbunden, die den Dampf in die Nähe des Substrat 20 leitet.

Innerhalb der Vakuumkammer 1 ist ein Aufschmelzbehälter 8 angeordnet. In diesen Aufschmelzbehälter wird festes Verdampfergut 21 eingebracht und mittels ebenfalls nicht näher dargestellten Heizeinrichtung so weit erwärmt, dass es schmilzt. Vorzugsweise besteht das Verdampfergut aus Metall oder metallischen Legierungen.

Der Aufschmelzbehälters 8 ist mit dem Verdampfer 2 über eine Verbindungsleitung 10 verbunden. Dabei ist der Fluss von flüssigem Verdampfungsgut über ein Flüssigmetallventil 29 und eine Flüssigmetallpumpe 30 steuerbar.

Zwischen der freien Atmosphäre 7 und der Vakuumkammer 1 ist eine Schleuse 23 angeordnet. Diese Schleuse 23 besteht aus einer Schleusenkammer 24, die durch ein jeweils getrennt schaltbares äußeres Ventil 26 und ein inneres Ventil 28 trennbar ist. Durch diese Schleuse 23 wird nunmehr das feste Verdampfungsgut 21 dem Aufschmelzbehälter 8 zugeführt. Dazu ist der Aufschmelzbehälter mit einem Verschluss 31 versehen, der geöffnet werden kann wenn nach Öffnung des inneren Ventils 28 neues Verdampfungsgut 21 dem Aufschmelzbehälter zugeführt werden soll.

Da einige Zeit vergeht, ehe neues festes Verdampfungsgut in die flüssige Phase übergegangen ist, ist ein zweiter Aufschmelzbehälter 32 in gleicher Weise angeordnet, wie der Aufschmelzbehälter 8. Er ist auch mit einer zweiten eigenen Schleuse 33, die in gleicher Art wie die Schleuse 23 aufgebaut ist, versehen. Durch diese zweite Aufschmelzkammer 32 kann Verdampfungsgut 21 eingebracht und langsam in die flüssige Phase gebracht werden, währenddessen der Verdampfer aus dem Flüssigraum 9 des anderen Aufschmelzbehälters 8 versorgt wird. Die Steuerung, welcher der Aufschmelzbehälter 8 oder 32 den Verdampfer versorgt, übernehmen die Flüssigmetallventile 29 oder die Flüssigmetallpumpen 30.

Bei dieser Ausführungsform kann auch wieder die Verbindung nach dem Prinzip der kommunizierenden Röhren gewählt werden oder - wie in Fig. 3 dargestellt, eine höhere Anordnung der Aufschmelzbehälter 8 und 32 gewählt werden, so dass das flüssige Verdampfungsgut 4 in den Verdampfer 2 drückt.

### Bezugzeichenliste

- 1: Vakuumkammer
- 2: Verdampfer
- 3: Flüssigkeitswanne
- 4: flüssiges Verdampfungsgut
- 5: Verdampferraum
- 6: Dampfleitung
- 7: freie Atmosphäre
- 8: Aufschmelzbehälter
- 9: Flüssigraum
- 10: Verbindungsleitung
- 11: Flüssigkeitsspiegel im Flüssigraum
- 12: Flüssigkeitsspiegel in der Flüssigkeitswanne
- 13: Abstand
- 14: Flüssigmetallpumpe
- 15: Rücklaufleitung
- 16: Trennwand
- 17: erstes Teilvolumen
- 18: zweites Teilvolumen
- 19: drittes Teilvolumen
- 20: Substrat
- 21: festes Verdampfungsgut
- 22: Rührwerk
- 23: Schleuse
- 24: Schleusenkammer
- 25: Schleusenkammer
- 26: äußeres Ventil
- 27: mittleres Ventilsystem
- 28: inneres Ventil
- 29: Flüssigkeitsmetallventil
- 30: Flüssigmetallpumpe
- 31: Verschluss
- 32: zweiter Aufschmelzbehälter
- 33: zweite Schleuse

## Patentansprüche

1. Vakuumbeschichtungsverfahren bei dem Verdampfungsgut durch Aufschmelzen in eine flüssige Phase gebracht wird, aus diesem flüssigen Verdampfungsgut in einer Vakuumkammer, in dem ein Prozessvakuum eingestellt ist, mittels eines Verdampfers ein Dampf erzeugt wird der innerhalb des Prozessvakuums auf eine Oberfläche eines Substrates zur Kondensierung auf dieser Substratoberfläche gebracht wird, und das Verdampfungsgut von außerhalb der Vakuumkammer bei ununterbrochenem Prozessvakuum in die Vakuumkammer eingebracht und dem Verdampfer über eine Verbindungsleitung fließend zugeführt wird **dadurch gekennzeichnet, dass** das Verdampfungsgut einem Aufschmelzbehälter innerhalb der Vakuumkammer zugeführt wird und von dieser über die Verbindungsleitung dem Verdampfer zugeführt wird und das Verdampfungsgut über eine Schleuse in fester Form in die Vakuumkammer eingebracht und innerhalb der Vakuumkammer aufgeschmolzen wird.

2. Vakuumbeschichtungsverfahren nach Anspruch 1,
**dadurch gekennzeichnet, dass** das feste Verdampfungsgut durch eine zyklisch wiederholendes Öffnen der Schleuse eingebracht wird.

3. Vakuumbeschichtungsverfahren nach Anspruch 1,
**dadurch gekennzeichnet, dass** das Verdampfungsgut zu einem ersten Zeitpunkt einem ersten Aufschmelzbehälter und zu einem zweiten Aufschmelzbehälter zugeführt wird und das flüssige Verdampfungsgut nach dem ersten Zeitpunkt dem Verdampfer von dem ersten Aufschmelzbehälter und nach dem zweiten Zeitpunkt aus dem zweiten Aufschmelzbehälter zugeführt wird.

4. Vakuumbeschichtungsverfahren nach einem der Ansprüche 1 bis 3, **dadurch gekennzeichnet, dass** das flüssige Verdampfungsgut dem Verdampfer nach dem Prinzip der kommunizierenden Röhren zugeführt wird.

5. Vakuumbeschichtungsverfahren nach einem der Ansprüche 1 bis 3, **dadurch gekennzeichnet, dass** das flüssige Verdampfungsgut dem Verdampfer durch Pumpen zugeführt wird.

6. Vakuumbeschichtungsverfahren nach einem der vorstehenden Ansprüche, **dadurch gekennzeichnet, dass** die Höhe des Füllstandes in dem Aufschmelzbehälter geregelt wird.

7. Vakuumbeschichtungsverfahren nach einem der vorstehenden Ansprüche **dadurch gekennzeichnet, dass** der Fluss in der Verbindungsleitung gesteuert wird.

8. Vakuumbeschichtungsverfahren nach einem der vorstehenden Ansprüche, **dadurch gekennzeichnet, dass** die Zufuhr von Verdampfungsgut in Abhängigkeit von Prozessparametern gesteuert erfolgt.

9. Vakuumbeschichtungsverfahren nach einem der vorstehenden Ansprüche, **dadurch gekennzeichnet, dass** die Höhe des Füllstandes im Verdampfer **dadurch** konstant gehalten wird, dass in einem Überschuss gefördertes Verdampfungsgut über eine geheizte Rücklaufleitung in den Aufschmelzbehälter zurück geführt wird.

10. Anordnung zur Durchführung des Verfahrens nach einem der Ansprüche 1 bis 9 die eine Vakuumkammer, in der ein Prozessvakuum einstellbar ist, aufweist, in der ein flüssiges Verdampfungsgut aufnehmender und dieses Verdampfungsgut verdampfender Verdampfer, eine Substrataufnahme und eine Vorrichtung zur Zuführung von Verdampfungsgut angeordnet ist, und ein das Verdampfungsgut schmelzender und flüssiges Verdampfungsgut aufnehmender Aufschmelzbehälter vorgesehen ist, der mit dem Verdampfer über eine Verbindungsleitung verbunden ist **dadurch gekennzeichnet, dass** der Aufschmelzbehälter innerhalb der Vakuumkammer angeordnet ist und eine festes Verdampfungsgut in die Vakuumkammer einführende Zuführeinrichtung vorgesehen ist, über die der Aufschmelzbehälter ohne Unterbrechung des Prozessvakuums mit Verdampfungsgut beschickbar ist und die Zuführeinrichtung eine Schleuse einschließt, über die das Verdampfungsgut in fester Form einbringbar ist.

11. Anordnung nach Anspruch 10, **dadurch gekennzeichnet, dass** neben dem Aufschmelzbehälter ein zweiter alternativ mit festen Verdampfungsgut beschickbarer Aufschmelzbehälter angeordnet ist.

12. Anordnung nach Anspruch 11, **dadurch gekennzeichnet, dass** korrespondierend zu dem zweiten Aufschmelzbehälter eine zweite Zuführeinrichtung angeordnet ist.

13. Anordnung nach einem der Ansprüche 10 bis 12, **dadurch gekennzeichnet, dass** Aufschmelzbehälter und Verdampfer über die Verbindungsleitung nach dem Prinzip der kommunizierenden Röhren verbunden sind.

14. Anordnung nach Anspruch 10 oder einem von diesem abhängigen Anspruch, **dadurch gekennzeichnet, dass** zwischen Aufschmelzbehälter und Verdampfer eine Flüssigmetallpumpe und/oder ein Flüssigkeitsventil angeordnet ist.

15. Anordnung nach Anspruch 10 oder einem von diesem abhängigen Anspruch, **dadurch gekennzeichet**, dass der Aufschmelzbehälter mit einem Ventil verschließbar ist, dass beim Beschicken mit festem Verdampfungsgut öffenbar ist und das Ventil als zweistufiges Ventil in der Art einer Schleuse ausgebildet ist.

## Claims

1. Vacuum coating method in which vaporization material is brought into a liquid phase by melting, in a vacuum chamber in which a process vacuum is created, a vaporizer generates from this liquid vaporization material a vapour which is brought inside the process vacuum onto a surface of a substrate in order to condense on this substrate surface, and the vaporization material is introduced into the vacuum chamber from outside the vacuum chamber without the process vacuum being interrupted and is fed to the vaporizer in a flowing fashion via a connecting line, **characterized in that** the vaporization material is fed to a melting vessel inside the vacuum chamber and is fed therefrom to the vaporizer via the connecting line, and the vaporization material is introduced into the vacuum chamber in solid form via a lock and is melted inside the vacuum chamber.

2. Vacuum coating method according to Claim 1, **characterized in that** the solid vaporization material is introduced by cyclically repeating opening of the lock.

3. Vacuum coating method according to Claim 1, **characterized in that** the vaporization material is fed at a first instant to a first melting vessel and to a second melting vessel, and the liquid vaporization material is fed after the first instant to the vaporizer from the first melting vessel, and after the second instant from the second melting vessel.

4. Vacuum coating method according to one of Claims 1 to 3, **characterized in that** the liquid vaporization material is fed to the vaporizer using the principle of communicating tubes.

5. Vacuum coating method according to one of Claims 1 to 3, **characterized in that** the liquid vaporization material is fed to the vaporizer by pumping.

6. Vacuum coating method according to one of the preceding claims, **characterized in that** the height of the filling level in the melting vessel is regulated.

7. Vacuum coating method according to one of the preceding claims, **characterized in that** the flow in the connecting line is controlled.

8. Vacuum coating method according to one of the preceding claims, **characterized in that** the vaporization material is fed in a controlled fashion as a function of process parameters.

9. Vacuum coating method according to one of the preceding claims, **characterized in that** the height of the filling level in the vaporizer is kept constant by virtue of the fact that excess vaporization material conveyed is guided back into the melting vessel via a heated return line.

10. Arrangement for carrying out the method according to one of Claims 1 to 9 which has a vacuum chamber, in which a process vacuum can be created and in which there are arranged a vaporizer, which holds liquid vaporization material and vaporizes said vaporization material, a substrate holder and a device for feeding vaporization material, and there is provided a melting vessel which melts the vaporization material and holds liquid vaporization material and is connected to the vaporizer via a connecting line, **characterized in that** the melting vessel is arranged inside the vacuum chamber, and **in that** a feeding device introducing solid vaporization material into the vacuum chamber is provided, via which feeding device the melting vessel can be loaded with vaporization material without the process vacuum being interrupted, and the feed device includes a lock via which the vaporization material can be introduced in solid form.

11. Arrangement according to Claim 10, **characterized in that** arranged next to the melting vessel is a second melting vessel which can alternatively be loaded with solid vaporization material.

12. Arrangement according to Claim 11, **characterized in that** a second feed device is arranged in a manner corresponding to the second melting vessel.

13. Arrangement according to one of Claims 10 to 12, **characterized in that** the melting vessel and vaporizer are connected via the connecting line using the principle of communicating tubes.

14. Arrangement according to Claim 10 or a claim dependent thereon, **characterized in that** a liquid metal pump and/or a liquid valve are/is arranged between the melting vessel and vaporizer.

15. Arrangement according to Claim 10 or a claim dependent thereon, **characterized in that** the melting vessel can be closed by a valve which can be opened when solid vaporization material is being loaded, and the valve is designed as a two-stage valve in the manner of a lock.

## Revendications

1. Procédé de revêtement sous vide dans lequel
une substance à vaporiser est amenée en phase liquide par fusion,
une vapeur de cette substance liquide à vaporiser est formée au moyen d'un évaporateur dans une chambre sous vide, dans laquelle un vide de traitement est établi, et est amenée dans le vide de traitement sur une surface d'un substrat de manière à se condenser sur cette surface du substrat,
la substance à vaporiser étant amenée dans la chambre sous vide depuis l'extérieur de la chambre sous vide et sans interrompre le vide de traitement et étant amenée à l'évaporateur en s'écoulant par un conduit de raccordement,
**caractérisé en ce que**
la substance à vaporiser est amenée dans un récipient de fusion situé à l'intérieur de la chambre sous vide et est amenée de celui-ci à l'évaporateur par le conduit de raccordement et
**en ce que** la substance à vaporiser est apportée sous forme solide dans la chambre sous vide par l'intermédiaire d'un sas et est fondue à l'intérieur de la chambre sous vide.

2. Procédé de revêtement sous vide selon la revendication 1, **caractérisé en ce que** la substance solide à vaporiser est amenée par ouverture cycliquement répétée du sas.

3. Procédé de revêtement sous vide selon la revendication 1, **caractérisé en ce qu'**à un premier instant, la substance à vaporiser est amenée dans un premier récipient de fusion et dans un deuxième récipient de fusion, la substance liquide à vaporiser étant amenée après le premier instant à l'évaporateur en provenance du premier récipient de fusion et après le deuxième instant en provenance du deuxième récipient de fusion.

4. Procédé de revêtement sous vide selon l'une des revendications 1 à 3, **caractérisé en ce que** la substance liquide à vaporiser est amenée à l'évaporateur en appliquant le principe des vases communicants.

5. Procédé de revêtement sous vide selon l'une des revendications 1 à 3, **caractérisé en ce que** la substance liquide à vaporiser est amenée à l'évaporateur par pompage.

6. Procédé de revêtement sous vide selon l'une des revendications précédentes, **caractérisé en ce que** le niveau dans le récipient de fusion est régulé.

7. Procédé de revêtement sous vide selon l'une des revendications précédentes, **caractérisé en ce que** l'écoulement dans le conduit de raccordement est contrôlé.

8. Procédé de revêtement sous vide selon l'une des revendications précédentes, **caractérisé en ce que** l'amenée de substance à vaporiser s'effectue de manière contrôlée en fonction de paramètres du traitement.

9. Procédé de revêtement sous vide selon l'une des revendications précédentes, **caractérisé en ce que** le niveau dans l'évaporateur est maintenu constant en renvoyant dans le récipient de fusion, par un conduit de retour chauffé, l'excès de substance à vaporiser qui a été transportée.

10. Système pour mettre en oeuvre le procédé selon l'une des revendications 1 à 9, qui présente
une chambre sous vide dans laquelle un vide de traitement peut être établi et dans laquelle sont disposés un évaporateur qui reprend une substance liquide à vaporiser et vaporise cette substance à vaporiser, un logement de substrat et un dispositif d'amenée de substance à vaporiser,
un récipient de fusion qui fait fondre la substance à vaporiser et qui reprend la substance liquide à vaporiser étant prévu et étant relié à l'évaporateur par un conduit de raccordement, **caractérisé en ce que**
le récipient de fusion est disposé à l'intérieur de la chambre sous vide,
**en ce qu'**un dispositif d'amenée qui introduit une substance solide à vaporiser dans la chambre sous vide et par lequel le récipient de fusion peut être alimenté en substance à vaporiser sans interrompre le vide de traitement est prévu et
**en ce que** le dispositif d'amenée inclut un sas par lequel la substance à vaporiser peut être introduite sous forme solide.

11. Système selon la revendication 10, **caractérisé en ce qu'**en plus du récipient de fusion, un deuxième récipient de fusion qui peut être alimenté en substance solide à vaporiser est prévu en variante.

12. Système selon la revendication 11, **caractérisé en ce qu'**un deuxième dispositif d'amenée est prévu en correspondance avec le deuxième récipient de fusion.

13. Système selon l'une des revendications 10 à 12, **caractérisé en ce que** le récipient de fusion et l'évaporateur sont reliés par le conduit de raccordement en appliquant le principe des vases communicants.

14. Système selon la revendication 10 ou une revendication qui lui est subordonnée, **caractérisé en ce qu'**une pompe à métal liquide et/ou une soupape à liquide sont disposées entre le récipient de fusion et l'évaporateur.

15. Système selon la revendication 10 ou une revendication qui lui est subordonnée, **caractérisé en ce que** le récipient de fusion peut être fermé par une soupape qui peut être ouverte lors de l'apport de substance solide à vaporiser et **en ce que** la soupape est configurée comme soupape à deux étages de type sas.
